Europäisches Patentamt

European Patent Office

Office européen des brevets

(11) Publication number: **0 470 610 B1**

# EUROPEAN PATENT SPECIFICATION

(45) Date of publication of patent specification: **19.07.95**   (51) Int. Cl.⁶: **C23C  14/20**

(21) Application number: **91113319.7**

(22) Date of filing: **08.08.91**

(54) **Synthetic resin molded article having metallic thin film on the surface thereof.**

(30) Priority: **09.08.90 JP 209158/90**

(43) Date of publication of application:
**12.02.92 Bulletin  92/07**

(45) Publication of the grant of the patent:
**19.07.95 Bulletin  95/29**

(84) Designated Contracting States:
**CH DE FR GB IT LI SE**

(56) References cited:
**DE-A- 3 333 381**

**PATENT ABSTRACTS OF JAPAN, vol. 8, no.
85 (C-219), 18 April 1984; & JP-A-59 006 250**

**PATENT ABSTRACTS OF JAPAN, vol. 14, no.
197 (C-712), 23 April 1990; & JP-A-20 38 578**

**DATABASE WPIL, Week 9123, Derwent Publications Ltd., London, GB; AN 91-167704; &
JP-A-31 00 197**

**PATENT ABSTRACTS OF JAPAN, vol. 6, no.
143 (C-117),3 August 1982; & JP-A-57 065 748**

**DATABASE WPIL, Week 8503, Derwent Publications Ltd., London, GB; AN 85-015050; &**

**JP-A-59 210 950**

(73) Proprietor: **YKK CORPORATION
No. 1, Kanda Izumi-cho
Chiyoda-ku,
Tokyo (JP)**

(72) Inventor: **Funakawa, Shigeru
1732, Funami,
Nyuzen-machi,
Shimoniikawa-gun
Toyama (JP)**
Inventor: **Yamaguchi, Yoshiharu
122-5, Oiwake
Namerikawa-shi,
Toyama (JP)**

(74) Representative: **Casalonga, Axel et al
BUREAU D.A. CASALONGA - JOSSE
Morassistrasse 8
D-80469 München (DE)**

**Description**

The present invention relates to a synthetic resin molded article having on its surface a metallic thin film having a surface gloss characteristic of a metal and excellent adhesion, dry cleaning resistance and resistance to washing with hot water.

The present inventors have already filed patent applications on synthetic resin molded articles having a metallic thin film on the surface thereof. For example, one comprising a synthetic resin substrate, a metallic coating layer formed on the substrate by vapor phase deposition and a topcoating layer provided on the metallic coating layer, one comprising a synthetic resin substrate, an adhesive undercoating layer provided on the surface of the substrate, a metallic coating layer provided on the surface of the undercoating layer and a topcoating layer provided on the surface of the metallic coating layer (see Japanese Patent Application Laid-Open No. 3 - 12103), and one comprising a synthetic resin substrate, a metallic coating layer formed on the surface of the substrate by vapor phase deposition, an undercoating layer provided on the surface of the metallic coating layer and a metallic coating layer and a topcoating layer both provided theron (see Japanese Patent Application Laid-Open no. 3 - 130357).

Conventional synthetic resin molded articles having a metallic thin film were produced in order to form a metallic thin film having a surface gloss characteristic of a metal and an excellent adhesion on the surface of a substrate comprising a synthetic resin material produced by various processes. In Japanese Patent Application Laid-Open No. 3 - 130357, when a resin having poor adhesive properties is used, the metallic thin film formation process disclosed in this application is practically applicable to a product made from the synthetic resin material alone (for example, a buckle). However, when the synthetic resin product also contains a fiber, there is a problem that the synthetic resin is detrimentally influenced by a gaseous component (moisture) contained in the fiber, which lowers the adhesion of a metallic thin film on the surface of the substrate during vapor phase deposition, so that peeling occurs as opposed to the above-described product made from the synthetic resin material alone which causes no peeling. When a metallic thin film is plated or a coating layer (an adhesive material) is applied onto a substrate made of a synthetic resin having poor adhesive properties, the plating or application depends upon the adhesion and bondability of the synthetic resin material, so that the adhesion of the metallic thin film or the like to a resin containing a fiber, is inferior to the adhesion of the metallic thin film to a product made from a synthetic resin alone by a synergistic effect of the adhesion or bondability and the moisture in the fiber.

Patent Abstracts of Japan, Vol. 8, No. 85 (C-219), 18 April 1984, and JP-A-59 006250 disclose a resin composition having good adaptability for metallization which comprises a resin material consisting of polytetramethylene terephtalate or a mixture thereof with a resin, rubber-modified acrylic resin, polycarbonate resin and polyester/polyether block copolymer, and a fibrous filler such as glass fiber.

Patent Abstracts of Japan, Vol. 14, No. 197 (C-712) 23 April 1990, and JP-A-20 38578 disclose a resin composition having superior adhesion by electroless plating through etching the surface with an etching solution. The resin composition is an alloy resin comprising polyphenylene oxide and polyamide.

Accordingly, an object of the present invention is to solve the above-described problems and to provide a synthetic resin molded article provided with a metallic thin film which has an excellent adhesion, a surface gloss characteristic of a metal and excellent dry cleaning resistance and resistance to washing with hot water, even in the case of a synthetic resin article containing a fiber.

The present invention relates to a synthetic resin molded article comprising a substrate made from a synthetic resin and a surface layer formed on the surface of the substrate characterized in that the synthetic resin is a polymer alloy of a polyamide resin or a polybutylene terephtalate resin with a modified ABS resin, a modified maleimide resin, a modified polyphenylene ether resin or a modified polyphenylene oxide resin, optionally including a fiber portion, and said surface layer comprises an undercoating layer and a metallic thin film successively provided in that order on the substrate.

The synthetic resin molded article may include a fiber portion, such as a fastener tape, ball chain, etc.

The present invention also relates to a process for making a synthetic resin molded article comprising a substrate made of a synthetic resin and a surface layer, characterized in that it comprises:
- forming a synthetic resin substrate which is an alloy of a polyamide resin or a polybutylene terephtalate resin with a modified ABS resin, a modified maleimide resin, a modified polyphenylene ether resin or a modified polyphenylene oxide resin, optionally including a fiber portion; and
- forming on said substrate said surface layer by:
(i) applying an undercoating material onto the substrate and then depositing in vapor phase a metallic thin film onto said undercoating; or
(ii) hot stamping an undercoating layer and a metallic thin film onto said substrate.

Synthetic resin materials are generally classified into a crystalline resin and an amorphous resin. Examples of the crystalline resin include polyamide resins and polybutylene terephtalate resins. In general, these resin materials are hard and stiff and advantageously excellent in their resistances to chemicals, friction and abrasion, and fluidity, while they have drawbacks such as high fragility, high molding shrinkage, poor dimensional stability and poor bondability and adhesion. Examples of the amorphous resin include modified ABS resin, modified maleimide resin, modified polyphenylene ether and modified polyphenylene oxide. These resin materials have properties opposite to those of the above-described crystalline resins, i.e., are excellent in the properties which are the drawbacks of the crystalline resin and poor in the properties which are the advantages of the crystalline resins.

Accordingly, when the crystalline resin and the amorphous resin having properties opposite to those of the crystalline resin are polymer-alloyed with each other, it becomes possible to prepare a synthetic resin material having such properties that the advantages of both the materials are utilized and the disadvantages are alleviated. For example, a synthetic resin material having excellent adhesion and bondability as well as dry cleaning resistance and resistance to washing with hot water can be prepared. Therefore, it is possible to prepare a synthetic resin molded article having a metallic thin film having excellent adhesion (bondability) and solvent resistance (chemical resistance) through the application of a coating layer, the formation of a metallized layer by vapor phase deposition or the formation of a surface layer by hot stamping.

The term "vapor phase deposition" used in the present invention is intended to mean, for example, vacuum deposition, ion plating and sputtering. For example, a metal or an alloy, such as aluminum, chromium, nickel, stainless steel, gold, silver, copper or brass, is deposited by these means to form a thin film as a surface layer.

In the present invention, the surface layer formed by hot stamping is intended to mean a surface layer formed by forming an undercoating layer onto a metallic thin film at the side to be adhered to a substrate surface and abutting the undercoating layer against the surface of a substrate and applying heat to the metallic thin film to form a metallic thin film on the surface of the substrate, or a surface layer formed by forming an undercoating on the surface of a substrate, providing a metallic thin film on the undercoating layer and applying heat to the metallic thin film. In this case, the heat to be applied is, for example, at a relatively low temperature of 50 to 60 °C or a relatively high temperature of 180°C or above.

The present invention exhibits an effect useful for practical use when use is made of a synthetic resin molded article having a fiber portion.

Further, the synthetic resin molded article having a surface layer of a metallic thin film may have either a structure comprising a metallic thin film provided on an undercoating layer and a topcoating layer provided on the surface of the metallic thin layer, or a structure comprising a metallic thin film, an undercoating layer, another metallic thin film and a topcoating layer provided on a substrate in that order.

The coating material used in the undercoating layer and topcoating layer comprises a thermally reactive, electron beam curable or ultraviolet curable synthetic resin, such as an acrylic, urethane, polyester, urea-melamine, epoxy, aminoalkyd, polyisocyanate or alkyl titanate resin, or nitrocellulose. The undercoating material is sprayed onto the surface of the substrate or the metallic thin film to form an undercoating layer and has an excellent adhesion to the surface of the substrate or the metallic thin film. The topcoating material is sprayed on the metallic thin film and then dried. This layer serves to impart an excellent metallic gloss and, at the same time, to enhance the adhesion and resistance to washing. The topcoating layer should be transparent or translucent so that the color tone of the metallic thin film provided under the topcoating layer can be seen through the topcoating layer. Alternatively, the topcoating layer may have an arbitrary color which does not prevent the color tone of the metallic thin film from being seen through the topcoating layer. For example, a synthetic resin molded article having a gloss characteristic of a golden metal can be produced by applying a yellow topcoating layer on a metallic thin film of aluminum having a silver gloss. It is also possible to obtain a gloss characteristic of a green metal through the application of a green topcoating layer on a metallic thin film of aluminum. Thus, topcoating layers having various colors which do not prevent the metallic thin film from being seen through the topcoating layer may be applied on the metallic thin film to produce a decorative material having a gloss characteristic of a metal corresponding to the color.

The vapor phase deposition used in the present invention will now be described by taking ion plating as an example. In ion plating, a metallic thin film is formed on the surface of a substrate by introducing an inert gas, for example, an argon gas into a vacuum apparatus through a gas inlet tube, arranging a substrate comprising a synthetic resin or a synthetic resin having an undercoating layer on the surface thereof as a cathode opposite to an evaporation source of a predetermined metallic material within the apparatus, applying a voltage across both materials to evaporate atoms, molecules or clusters of the predetermined metallic material from the evaporation source, ionizing them in a high-frequency electric field generated through the application of a voltage to a high-frequency coil provided between the substrate and the evaporation source, and irradiating the surface of the substrate with high-energy ions thus formed. In this case, the high-energy ions are accelerated in the high-frequency electric field and collide with the surface of the substrate. This causes the collided portion of the substrate to be locally heated to a very high temperature by the very high energy of the particles, so that the particles firmly adhere to the surface of the substrate. Further, a high energy is given to the atoms of a metallic thin film comprising a predetermined metallic material and formed through ion implantation by means of ion bombardment and mixing accompanying the ion implantation to cause the lattice elements of the metallic layer to have a violent movement, so that a high-density defect is formed on the surface and interface, thus causing a tough metallic thin film having a good adhesion to be formed. Ultrasonic cleaning and etching of the surface of the material having an oleaginous layer or an impurity enables an active and clean resin surface to be prepared and factors detrimental to the adhesion of the metallic thin film to be removed.

In the above-described embodiment, when the evaporation source is aluminum and the roughness of the surface of the substrate exceeds, for example, 0.1 $\mu$m, a metallic thin film of aluminum having a thickness of, 0.1 $\mu$m or less turns grayish white, so that no surface having a surface gloss characteristic of a metal can be obtained. In this case, a silver color having a gloss characteristic of a metal can be obtained by applying an undercoating material having a good adhesion to aluminum (for example, one comprising a polyester polyol as a main agent and a polyisocyanate as a curing agent) and further forming a metallic thin film comprising aluminum. Further, in order to protect the metallic thin film, a topcoating material may be applied on the metallic thin film to form a synthetic resin molded article having excellent adhesion and abrasion resistance and a surface gloss characteristic of a metal.

Thus, the provision of a surface layer having the above-described constitution on the surface of a substrate comprising a synthetic resin material prepared by polymer-alloying a crystalline resin with an amorphous resin serves to give a synthetic resin molded article having a better surface adhesion and a surface gloss characteristic of a metal and, at the same time, provides a synthetic resin molded article having a color in compliance with the customer's desire. Further, in the provision of a surface layer having the latter constitution, a polar metallic thin film is provided between a substrate comprising a nonpolar or nearly nonpolar synthetic resin material and a nonpolar or nearly nonpolar undercoating layer and, then, another polar metallic thin film is formed between the undercoating layer and a nonpolar or nearly nonpolar topcoating layer and, in such an arrangement, better interlaminar adhesion can be obtained.

The present invention will now be described in more detail by way of the following Examples.

Example 1

A polyamide resin was polymer-alloyed with a modified maleimide resin in a proportion of 1 : 1 to prepare a synthetic resin material, which was injection molded together with a fastener tape and a ball chain (made of a fiber) into an element and a ball comprising the synthetic resin material. The surface roughness of the substrate was 0.1 $\mu$m or above. The resultant molded article was subjected to ultrasonic washing with flon (chlorofluorocarbon), and a metallic thin film comprising aluminum or chromium having a thickness of 0.05 to 0.1 $\mu$m was formed thereon by high-frequency ion plating. An undercoating material comprising a blend of 100 parts of a polyester solution with 30 parts of a polyisocyanate was sprayed onto the surface of the metallic thin film by means of a spray gun and heat-cured by hot air at 90°C for 60 min. A metallic thin film of aluminum having a thickness of 0.05 to 0.1 $\mu$m was formed thereon by ion plating. Further, a topcoating material comprising a blend of 100 parts of a polyester solution with 10 parts of polyisocyanate and a yellow dye was sprayed thereon by means of a spray gun. The topcoating material was heat-cured by hot air at 70°C for 60 min. Thus, a golden surface layer having a good durability was formed on the synthetic resin substrate. The same surface layer as set forth above was formed on each of a polymer alloy substrate comprising polyamide and modified polyphenylene ether (hereinafter referred to as "PPE"), a polymer alloy substrate comprising polyamide and modified polyphenylene oxide (hereinafter referred to as "PPO"), a polymer alloy substrate comprising polyamide and modified ABS, a polymer alloy substrate comprising polybutylene terephthalate (hereinafter referred to as "PBT") and modified PPO, and a polymer alloy substrate comprising PBT and modified PPE. In the injection molding of each substrate, a fastener tape and a ball chain, both made of a fiber, were incorporated into each resin material, as set forth above.

A surface layer comprising a metallic thin film, an undercoating layer, another metallic thin film and a topcoating layer, successively formed in that order onto the surface of a substrate of a synthetic resin, will be referred to as surface layer 1 hereinbelow.

Separately, a polyamide resin was polymer-alloyed with a modified maleimide resin in a proportion of 1 : 1 to prepare a synthetic resin material, which was injection molded together with a fastener tape and a ball chain, both made of a fiber, into an element and a ball comprising the synthetic resin material. The surface roughness of the substrate was 0.1 μm or above. The resultant molded article was subjected to ultrasonic washing with flon. An undercoating material comprising a blend of 100 parts of a polyester solution with 30 parts of a polyisocyanate was sprayed on the surface of the substrate by means of a spray gun and heat-cured by hot air at 90°C for 60 min. Thereafter, a metallic thin film was formed thereon by high-frequency ion plating in the same manner as described above. Further, a topcoating material was sprayed thereon to form a topcoating layer. Thus, a golden surface layer was formed on the surface of a substrate comprising a synthetic resin material. Further, the same surface layer as set forth above was formed onto a substrate comprising each of the combinations of crystalline resins and amorphous resins shown in Table 1 below. In the injection molding of each substrate, a fastener tape and a ball chain, both made of a fiber, were incorporated into each resin material, as set forth above.

A surface layer comprising an undercoating layer, a metallic layer and a topcoating layer, successively formed in that order onto the surface of a substrate of a synthetic resin, will be referred to as surface layer 2 hereinbelow.

The surface of each synthetic resin molded article thus formed was sectioned with a cutter to form 100 squares each having dimensions of 1 mm x 1 mm. Thereafter, JIS cellophane tape was adhered to the squares and then peeled to conduct a forced test and thereby determine the number of peeled squares per 100 squares.

For comparison, a similar forced test was conducted on samples wherein a surface layer 1 or a surface layer 2 was formed on a substrate comprising an injection molded article of an acetal resin, a polyamide resin, a PBT resin, an ABS resin or a polypropylene resin.

Further, regarding a product not containing a fiber (for example, a buckle), a similar forced test was conducted on samples wherein a surface layer 1 or a surface layer 2 was formed on the surface of the substrate of each of the above-mentioned synthetic resin materials. Further, a similar forced test was conducted on samples wherein each of the above-described synthetic resin materials was injection molded together with or without a fastener tape or a ball chain (both made of a fiber), as set forth above, and a hot stamping metallic transfer foil for an ABS resin was transferred on the surface of the molded article.

The results of the forced test are given in Table 1. Since the results for the hot stamping metallic transfer foil were the same in both cases of containing the fiber portion and not containing the fiber portion, they are shown in the same column in the table.

Table 1

| molding resin \ Presence of fiber / surface layer | containing fiber (fastener, etc.) surface layer 1 | containing fiber (fastener, etc.) surface layer 2 | free from fiber (buckle, etc.) surface layer 1 | free from fiber (buckle, etc.) surface layer 2 | hot stamping (–) |
|---|---|---|---|---|---|
| **Ex.** | | | | | |
| polyamide & modified maleimide | 0/100 | 0/100 | 0/100 | 0/100 | 0/100 |
| polyamide & modified PPE | 0/100 | 0/100 | 0/100 | 0/100 | 0/100 |
| polyamide & modified PPO | 0/100 | 0/100 | 0/100 | 0/100 | 0/100 |
| polyamide & modified ABS | 0/100 | 0/100 | 0/100 | 0/100 | 0/100 |
| PBT & modified PPO | 0/100 | 0/100 | 0/100 | 0/100 | 0/100 |
| PBT & modified PPE | 0/100 | 0/100 | 0/100 | 0/100 | 0/100 |
| **Comp. Ex.** | | | | | |
| acetal resin | 43/100 | 100/100 | 0/100 | 53/100 | 100/100 |
| polyamide resin | 25/100 | 100/100 | 0/100 | 45/100 | 100/100 |
| PBT resin | 27/100 | 100/100 | 0/100 | – | 100/100 |
| ABS resin | 0/100 | 0/100 | 0/100 | 0/100 | 0/100 |
| polypropylene resin | 53/100 | 100/100 | – | – | 0/100 |

Note:  Numerical values in the table represent the number of peeled squares per 100 squares.

Surface layer 1:  comprising a metallic thin film, an undercoating layer, another metallic thin film and a topcoating layer

Surface layer 2:  comprising an undercoating layer, a metallic thin film and a topcoating layer

As is apparent from Table 1, the synthetic resin molded articles having a metallic thin film on the surface thereof according to the present invention had an excellent adhesion not only when the molded article was free from a fiber but also when the molded article contained a fiber and had an excellent adhesion in the case of hot stamping as well.

Example 2

The same samples as those of the Example 1 were examined for dry cleaning resistance and resistance to washing with hot water.

The dry cleaning resistance was determined by washing these samples with a perchloroethylene solvent at about 23°C for 3 min, removing the solvent by high speed rotation, repeating the washing and the removal of the solvent three times, drying the samples at 50 to 60°C for about 15 min, and repeating the above-described procedure from the washing to the drying five times.

The resistance to washing with hot water was determined by washing the samples with 30 g/30 liters of a commercially available synthetic detergent at about 40 to 45°C for 30 min and rinsing the samples for 5 min, repeating the washing and, then, rinsing twice, drying the samples at 60°C for 30 min, and the repeating the above-described procedure from the washing to the drying 20 times.

The results of the determination of the dry cleaning resistance and resistance to washing with hot water are given in Table 2.

Table 2

| Properties molding resin | dry cleaning resistance | | resistance to washing with hot water | | |
|---|---|---|---|---|---|
| surface layer | surface layer 1 | surface layer 2 | surface layer 1 | surface layer 2 | hot stamping |
| **Ex.** | | | | | |
| Polyamide & modified maleimide | o | o | o | o | o |
| polyamide & modified PPE | o | o | o | o | o |
| ployamide & modified PPO | o | o | o | o | o |
| polyamide & modified ABS | o | o | o | o | o |
| PBT & modified PPO | o | o | o | o | o |
| PBT & modified PPE | o | o | o | o | o |
| **Comp. Ex.** | | | | | |
| acetal resin | o | o | x | x | x |
| polyamide resin | o | o | x | x | x |
| PBT resin | o | o | x | x | x |
| ABS resin | x | x | o | o | o |
| polypropylene resin | o | o | x | x | o |

In Table 2, the results of the evaluation are indicated by "o" and "x", wherein "o" means that the coating film was not peeled and there was observed neither the occurrence of cracks and swelling nor a change in the appearance in the molded article, and "x" means that there was observed the peeling of the coating film or the occurrence of cracks, swelling or other changes in appearance of the molded articles. As is apparent from Table 2, the synthetic resin molded articles having a metallic thin film on the surface thereof according to the present invention had excellent dry cleaning resistance and resistance to washing with hot water except for the dry cleaning resistance of the product prepared by hot stamping.

A surface gloss characteristic of a metal can be imparted by providing a surface layer 1 or a surface layer 2 on the surface of a substrate of a synthetic resin material even when the substrate is one prepared by a process such as injection molding (surface roughness: 0.1 $\mu$m or above).

According to the present invention, a crystalline resin is polymer-alloyed with an amorphous resin to alleviate various drawbacks and utilize the advantages of these resins, thereby giving a synthetic resin having excellent adhesion and solvent resistance, and a surface layer is provided on the surface of the synthetic resin material substrate, which serves to give a synthetic resin molded article having a surface gloss characteristic of a metal together with excellent adhesion and solvent resistance, so that the present invention exhibits an excellent effect is useful from the practical viewpoint.

Further, when a metallic thin film is provided on a synthetic resin portion of a synthetic resin product comprising a fiber portion and a synthetic resin portion, it is possible to obtain a product having a metallic thin film formed with a good adhesion on a substrate of a synthetic resin product including a fiber, even when a gaseous component (mainly moisture) is generated from the fiber portion during production so as to deteriorate the film's adhesion, since the metallic thin film is formed with a better adhesion.

It is also possible to produce a synthetic resin molded article provided with a metallic thin film having a surface gloss characteristic of a metal formed even on a substrate surface having a roughness of 0.1 $\mu$m or above through the adoption of a surface layer having a structure comprising an undercoating layer, a metallic thin film and a topcoating layer, or a structure comprising a metallic layer, an undercoating layer, a metallic thin film and a topcoating layer.

**Claims**

1. A synthetic resin molded article comprising a substrate made from a synthetic resin and a surface layer, characterized in that said synthetic resin is a polymer alloy of a polyamide resin or a polybutylene terephtalate resin with a modified ABS resin, a modified maleimide resin, a modified polyphenylene ether resin or a modified polyphenylene oxide resin, optionally including a fiber portion, and said surface layer comprises an undercoating layer and a metallic thin film successively provided in that order on the substrate.

2. A synthetic resin molded article according to claim 1, characterized in that said surface layer comprises another metallic thin film provided between the substrate and the undercoating layer.

3. A synthetic resin molded article according to claim 1 or 2, characterized in that said surface layer further comprises a topcoating layer on the metallic thin film provided on said undercoating layer.

4. A synthetic resin molded article according to anyone of claims 1 to 3, wherein the substrate further includes a fiber portion.

5. A process for making a synthetic resin molded article comprising a substrate made of a synthetic resin and a surface layer, characterized in that it comprises:
   - forming a synthetic resin substrate which is an alloy of a polyamide resin or a polybutylene terephtalate resin with a modified ABS resin, a modified maleimide resin, a modified polyphenylene ether resin or a modified polyphenylene oxide resin, optionally including a fiber portion; and
   - forming on said substrate said surface layer by:
     (i) applying an undercoating material onto the substrate and then depositing in vapor phase a metallic thin film onto said undercoating; or
     (ii) hot stamping an undercoating layer and a metallic thin film onto said substrate.

6. The process of claim 5, characterized in that it further comprises forming by vapor phase deposition or hot stamping on said substrate another metallic thin film prior to forming said undercoating layer.

7. The process of claim 5 or 6, characterized in that it further comprises forming a topcoating layer on the metallic thin film formed on said undercoating layer.

8. The process of anyone of claims 5 to 7, wherein the substrate further includes a fiber portion.

**Patentansprüche**

1. Geformter Gegenstand aus synthetischem Harz, umfassend ein aus einem syntethischen Harz gebildetes Substrat und eine Oberflächenschicht, dadurch gekennzeichnet, daß das synthetische Harz eine Polymerlegierung aus einem Polyamidharz oder einem Polybutylenterephtalatharz und einem modifizierten ABS-Harz, einem modifizierten Maleimidharz, einem modifizierten Polyphenylenätherharz oder einem modifizierten Polyphenylenoxidharz ist, wobei das Substrat wahlweise einen Faseranteil enthält und die Oberflächenschicht eine Grundierungsschicht und einen metallischen dünnen Film umfaßt, die in dieser Reihenfolge aufeinanderfolgend auf dem Substrat vorgesehen sind.

2. Geformter Gegenstand aus synthetischem Harz nach Anspruch 1, dadurch gekennzeichnet, daß die Oberflachenschicht einen weiteren zwischen dem Substrat und der Grundierungsschicht vorgesehenen, metallischen, dünnen Film umfaßt.

3. Geformter Gegenstand aus synthetischem Harz nach Anspruch 1 oder 2, dadurch gekennzeichnet, daß die Oberflächenschicht zusätzlich eine Abdeckschicht auf dem auf der Grundierungsschicht vorgesehenen, metallischen, dünnen Film umfaßt.

4. Geformter Gegenstand aus synthetischem Harz nach einem der Ansprüche 1 bis 3, bei dem das Substrat zusätzlich einen Faseranteil enthält.

5. Verfahren zum Herstellen eines ein aus einem synthetischen Harz gebildetes Substrat und eine Oberflächenschicht umfassenden, geformten Gegenstands aus synthetischem Harz, dadurch gekennzeichnet, daß es umfaßt:
   - Bilden eines Substrats aus einem synthetischen Harz, das eine Legierung aus einem Polyamidharz oder einem Polybutylenterephtalatharz und einem modifizierten ABS-Harz, einem modifizierten Maleimidharz, einem modifizierten Polyphenylenätherharz oder einem modifizierten Polyphenylenoxidharz ist und wahlweise einen Faseranteil enthält und
   - Bilden der Oberflächenschicht auf dem Substrat durch:
     (i) Aufbringen eines Grundierungsmaterials auf das Substrat und dann Abscheiden eines metallischen, dünnen Films auf der Grundierung aus der Gasphase oder
     (ii) Warmprägen einer Grundierungsschicht und eines metallischen, dünnen Films auf das Substrat.

6. Verfahren nach Anspruch 5, dadurch gekennzeichnet, daß es zusätzlich umfaßt: Bilden eines weiteren metallischen, dünnen Films auf dem Substrat mittels Gasphasenabscheidung oder Warmprägen vor dem Bilden der Grundierungsschicht.

7. Verfahren nach Anspruch 5 oder 6, dadurch gekennzeichnet, daß es zusätzlich umfaßt: Bilden einer Abdeckschicht auf dem auf der Grundierungsschicht gebildeten, metallischen, dünnen Film.

8. Verfahren nach einem der Ansprüche 5 bis 7, bei dem das Substrat zusätzlich einen Faseranteil enthält.

**Revendications**

1. Objet moulé en résine de synthèse comprenant un substrat fait d'une résine de synthèse et une couche superficielle, caractérisé en ce que ladite résine de synthèse est un alliage de polymères contenant une résine polyamide ou une résine poly(butylène téréphtalate) avec une résine ABS modifiée, une résine maléimide modifiée, une résine polyphénylène éther modifiée ou une résine polyphénylène oxyde modifiée, contenant éventuellement une partie fibreuse, et en ce que ladite couche superficielle comprend une sous-couche de revêtement et un mince film métallique placés successivement dans cet ordre sur le substrat.

2. Objet moulé en résine de synthèse selon la revendication 1, caractérisé en ce que ladite couche superficielle comprend un autre mince film métallique placé entre le substrat et la sous-couche de revêtement.

3. Objet moulé en résine de synthèse selon la revendication 1 ou 2, caractérisé en ce que ladite couche superficielle comprend en outre une surcouche de revêtement sur le mince film métallique placé sur ladite sous-couche de revêtement.

4. Objet moulé en résine de synthèse selon l'une quelconque des revendications 1 à 3, dans lequel le substrat contient en outre une partie fibreuse.

5. Procédé de fabrication d'un objet moulé en résine de synthèse qui comprend un substrat fait d'une résine de synthèse et une couche superficielle, caractérisé en ce qu'il comprend :
   - la formation d'un substrat en résine de synthèse qui est un alliage d'une résine polyamide ou d'une résine poly(butylène téréphtalate) avec une résine ABS modifiée, une résine maléimide modifiée, une résine polyphénylène éther modifiée ou une résine polyphénylène oxyde modifiée, contenant éventuellement une partie fibreuse, et
   - la formation sur ledit substrat de ladite couche superficielle en :
   (i) appliquant un matériau de sous-couche sur le substrat et déposant ensuite en phase vapeur un mince film métallique sur ladite sous-couche, ou
   (ii) estampant à chaud une sous-couche de revêtement et un mince film métallique sur ledit substrat.

6. Procédé selon la revendication 5, caractérisé en ce qu'il comprend en outre la formation par dépôt en phase vapeur ou estampage à chaud sur ledit substrat d'un autre mince film métallique avant la formation de ladite sous-couche de revêtement.

7. Procédé selon la revendication 5 ou 6, caractérisé en ce qu'il comprend en outre la formation d'une sur-couche de revêtement sur le mince métallique formé sur ladite sous-couche de revêtement.

8. Procédé selon l'une quelconque des revendications 5 à 7, dans lequel le substrat contient en outre une partie fibreuse.